(19) Europäisches Patentamt
European Patent Office
Office européen des brevets

(11) Veröffentlichungsnummer: **0 309 783**
**A2**

(12) # EUROPÄISCHE PATENTANMELDUNG

(21) Anmeldenummer: **88114536.1**

(22) Anmeldetag: **06.09.88**

(51) Int. Cl.4: **C08G 59/17 , C08G 59/30 , C08F 299/02 , H01B 3/40 , C03C 17/32**

(30) Priorität: **28.09.87 DE 3732603**

(43) Veröffentlichungstag der Anmeldung: **05.04.89 Patentblatt 89/14**

(84) Benannte Vertragsstaaten: **AT BE CH DE FR GB IT LI LU NL SE**

(71) Anmelder: **Siemens Aktiengesellschaft Berlin und München**
**Wittelsbacherplatz 2**
**D-8000 München 2(DE)**

(72) Erfinder: **Budde, Klaus, Dr. rer. nat.**
**Ottobrunner Strasse 5**
**D-8025 Unterhaching(DE)**
Erfinder: **Spiegel, Sabine, Dipl.-Chem.**
**Emil-Geis-Strasse 9**
**D-8000 München 70(DE)**

(54) **Strahlungsvernetzbare Harze für Anwendungen in der Elektronik.**

(57) Es wird ein insbesondere als Photoresist und Dielektrikum für Mikroverdrahtungen verwendbares, zu einem thermisch und chemisch stabilen Polymersystem vernetzbares Harz angegeben, welches durch Umsetzung von an sich bekannten, aus Bisphenol A ähnlichen fluorierten Phenolen aufgebauten Diglycidylethern mit im wesentlichen linearen, fluorierten aliphatischen Diolen und anschließender Veresterung sämtlicher freier OH- und Epoxidgruppen mit dem Säurechlorid einer substituierten Acrylsäure erhalten wird. Das Harz weist eine gegenüber dem Stand der Technik verbesserte Lichtempfindlichkeit bei guter Lagerungsfähigkeit auf. Im vernetzten Zustand zeigt der Lack gute dielektrische Eigenschaften bei hoher Glasübergangstemperatur und hoher thermischer Dauerbeständigkeit, wodurch er bestens zum Verbleib auf Bauelementen geeignet ist.

EP 0 309 783 A2

Xerox Copy Centre

## Strahlungsvernetzbare Harze für Anwendungen in der Elektronik.

Die Erfindung betrifft ein durch Strahlung zu einem thermisch und chemisch stabilen Polymersystem vernetzbares Harz mit substituierten Acrylestergruppierungen als strahlungsempfindliche Struktureinheiten sowie ein Verfahren zu seiner Herstellung.

Lichtempfindliche Harze bzw. Lacke finden in der Elektronik vielfältige Anwendungen, insbesondere als Photoresist. Bei mikroelektronischen Bauelementen mit Mehrlagenverdrahtung werden Photoresists eingesetzt, um die Leiterbahnstrukturen auf dem Substrat bzw. auf dem fertigen Bauelement zu definieren. Dazu wird eine auf einer Vorlage (Maske) gefertigte Struktur mittels optischer Methoden, überwiegend durch UV-Strahlung, auf eine vorbereitete Lackschicht übertragen. Die dadurch in den belichteten Bereichen bewirkte chemische Veränderung des Lackes macht eine Entwicklung des Bildes möglich. Bei Negativphotoresists werden die unbelichteten Bereiche zum Beispiel durch Lösungsmittel abgelöst. Die daraus resultierende Lackstruktur dient nun ihrerseits als Maske für weitere strukturerzeugende Schritte, zum Beispiel Abscheiden oder Erzeugen einer Schicht oder Ätzen einer darunterliegenden Schicht. Zumeist bildet der Lack nur eine Hilfsstruktur und muß vor weiteren Verfahrensschritten entfernt werden.

Soll der belichtete Lack jedoch auf dem Bauelement verbleiben, muß er zusätzliche Anforderungen erfüllen. Um weitere Verarbeitungsschritte des Bauelements unbeschadet zu überstehen, muß er chemisch stabil sein und gegen Hydrolyse und Lösungsmittel beständig sein. Weiterhin soll er thermisch stabil sein und eine Glasübergangstemperatur $T_g$ besitzen, die über den höchsten zum Beispiel beim Dauerbetrieb des Bauelements auftretenden Temperaturen liegt. Auch sollten gute elektrische Eigenschaften wie niedrige Dielektrizitätskonstante $\epsilon_r$ und niedrige Verlustwin kel tan$\delta$ gegeben sein.

Weit verbreitet ist der Einsatz von Negativphotoresists auf der Basis von Polyisoprenderivaten. Diese Lacke besitzen einen niedrigen $\epsilon_r$-Wert von ca. 2, zeigen hohe Reaktivität bei der Bestrahlung und haben eine gute Lagerstabilität. Ihre Verwendung beim Aufbau von Mehrlagenmikroverdrahtungen ist allerdings wegen ihrer niedrigen Glasübergangstemperaturen $T_g$ und hohen thermischen Ausdehnungskoeffizienten zumindest problematisch, wenn nicht ausgeschlossen.

Hohe thermische Belastbarkeit bei höherem $\epsilon_r$ zeigen Polyimidsysteme, wie zum Beispiel aus einem Artikel von Arthur M. Wilson in Thin Solid Films 83, 1981, Seiten 145 bis 163, bekannt ist. Doch auch hier ist die Erzeugung von feinen und feinsten Strukturen durch einen beim Aushärten des Lackes auftretenden Masseverlust von ca. 40 bis 50 Gewichtsprozent äußerst erschwert.

Niedriges $\epsilon_r$ bei einfacher Herstellung und guter Lagerstabilität zeigen Harze auf Bisphenol A Epichlorhydrinbasis mit Acrylsäurederivaten als lichtempfindlichen Gruppen. Diese zum Beispiel aus der deutschen Patentanmeldung P 3 424 119.1 bekannten Harze zeigen auch keinen Masseverlust beim Härten und haben einen niedrigen Ausdehnungskoeffizienten. Doch sind Lichtempfindlichkeit und Dauertemperaturbeständigkeit noch verbesserungsfähig.

Aufgabe der vorliegenden Erfindung ist es daher, einen verbesserten Photolack anzugeben, der im gehärteten Zustand eine hohe Glasübergangstemperatur von über 100°C bei gleichzeitig guter Dauertemperaturbeständigkeit (größer 100°C) zeigt und die oben erwähnten guten elektrischen Eigenschaften aufweist, um ihn bei gleichzeitiger chemischer Stabilität zur Erzeugung von Mehrlagenverdrahtungen verwenden zu können.

Diese Aufgabe wird durch ein Harz der eingangs genannten Art erfindungsgemäß dadurch gelöst, daß es überwiegend Polymere der allgemeinen Strukturformel (1) enthält

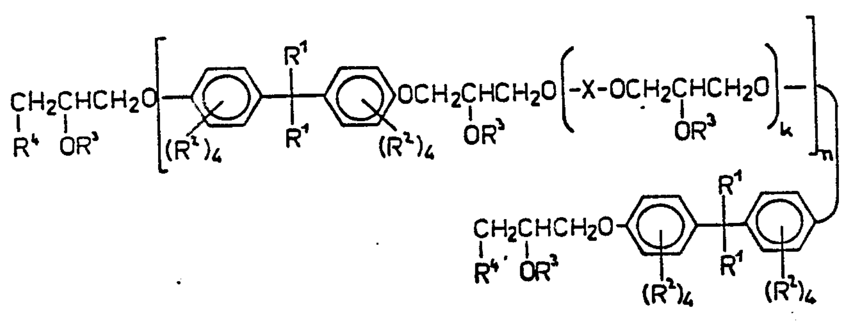

(1)

worin

X einen zweiwertigen, mindestens zum Teil fluorierten und im wesentlichen linearen aliphatischen Rest mit 2 bis 10 C-Atomen darstellt,
$R^3$ den Acylrest einer substituierten Acrylsäure bedeutet,
die Reste $R^1$ unabhängig voneinander Methyl- oder Trifluormethylreste sind,
die Reste $R^2$ unabhängig voneinander H, F, Br, $OR^3$, $CH_2OR^3$, $CH_3$, oder $CF_3$ bedeuten,
die Endgruppen $R^4$ entweder Cl oder $OXOR^3$ sind,
k die Zahl 1 ist sowie
n eine ganze Zahl zwischen 1 und 20 darstellt
und daß die übrigen Bestandteile des Harzes wahlweise für lichtempfindliche Mischungen übliche Zusätze sind, wie Vernetzungsverstärker, Photoinitiatoren und Stabilisatoren.

Weitere Ausgestaltungen der Erfindung, sowie ein Verfahren zur Herstellung des Harzes sind den Unteransprüchen zu entnehmen.

Das erfindungsgemäße Harz weist gegenüber den bekannten Bisphenol A/Epichlorhydrin/Acrylatsystemen eine um mehr als eine Größenordnung verbesserte Lichtempfindlichkeit auf und zeigt im vernetzten Zustand eine niedrige Dielektrizitätskonstante $\epsilon_r$ von ungefähr 3 und hohe thermische Dauerbeständigkeit bei mehr als 100 °C. Die Glasübergangstemperaturen liegen ebenfalls durch gehend über 100 °C. Ebenso erfüllt das Harz die Anforderungen an die chemische Stabilität und ist gegen Hydrolyse bzw. gegen andere Lösungsmittel unempfindlich. Dazu kommen noch weitere Vorteile des nicht vernetzten Harzes, wie eine gute Lagerungsfähigkeit, die im Bereich von mehreren Monaten bis mehrere Jahre liegt, eine einfache Verarbeitung, toxikologische Unbedenklichkeit und außerdem eine gute Löslichkeit in gängigen Lösungsmitteln wie zum Beispiel Aceton oder Toluol.

Die Erfindung geht von dem Gedanken aus, einen starren Baustein, wie ihn das Bisphenol A-Grundgerüst darstellt, mit geeigneten kurzen, beweglichen, in der Strukturformel (1) mit X bezeichneten Resten zu verbinden. Diese Reste sollen dabei möglichst unpolar sein und bestehen daher im wesentlichen aus linearen und unverzweigten fluorierten Aliphaten oder anderen fluorierten und zugleich symmetrischen Aliphaten. Durch einen hohen Fluorierungsgrad dieser aliphatischen Kette X wird eine Absenkung von $\epsilon_r$ erzielt, was in Übereinstimmung mit der Theorie von Van Krevelen et al in Properties of Polymers, Elsevier, Amsterdam 1972, Seiten 211 bis 215 steht.

Weiterhin wurde gefunden, daß ein möglichst starres und mit sterisch anspruchsvollen Gruppen substituiertes Bisphenol A Gerüst für die thermischen Eigenschaften des Polymers von Vorteil ist. Wegen der erwiesenermaßen günstigen Eigenschaften aliphatischer C-F Bindungen in bezug auf $\epsilon_r$ des Gesamtpolymers sind dabei $CF_3$-Gruppen als Substituenten bevorzugt. Doch sind auch Halogenatome oder Methylgruppen als Substituenten am aromatischen Ring des Bisphenols denkbar. In einer weiteren Ausgestaltung der Erfindung ist die Einführung von bis zu vier Hydroxymethylgruppen pro Aromaten des Bisphenols vorgesehen, wobei die Hydroxygruppen jeweils mit den entsprechenden Acrylsäuren verestert werden.

Die Auswahl der für die Esterbildung vorgesehenen, die lichtempfindlichen Gruppen tragenden substituierten Acrylsäuren umfaßt im wesentlichen Furanacrylsäure und Zimtsäure, sowie deren Derivate. Auch hier erweisen sich fluorierte Spezies, wie die am Aromaten perflorierte Zimtsäure, sowie die para-Trifluor methylzimtsäure als besonders vorteilhaft.

Zur Herstellung der erfindungsgemäßen Harze wird von den bekannten Diglycidylethern (2) ausgegangen, welche durch Umsetzen von Bisphenolen des Bisphenol A Typs mit einem Überschuß Epichlorhydrin gemäß Gleichung (I) erhalten werden.

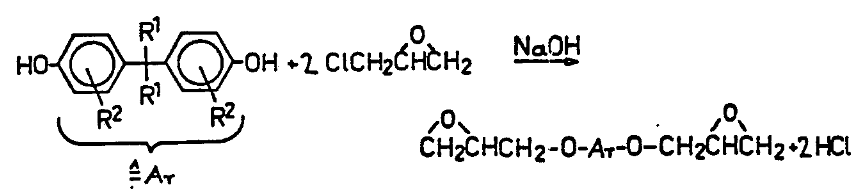


(I)

Durch Umsetzen der Diglycidylether mit relativ aciden fluorierten aliphatischen Diolen, die bevorzugt der Strukturformel (3) gehorchen, wobei l eine ganze Zahl mit 3 ≦ 1 ≦ 5 ist, werden die Polyfluoralkyldiglycidylether mit dem regelmäßig wiederkehrenden Strukturelement (4) erhalten.

$$-Ar-O-CH_2\overset{OH}{C}HCH_2O-CH_2(CF_2)_l CH_2-O-CH_2\overset{OH}{C}HCH_2-O- \quad (4)$$

$$HO-CH_2(CF_2)_l CH_2-OH \quad (3)$$

Entsprechend dem Mischungsverhältnis der Edukte werden die Endgruppen der Polyether (4) von Glycidylgruppen oder von Hydroxyfluoralkylresten gebildet.

Sämtliche Hydroxyl- und Epoxidgruppen des Polymeren (3) werden durch Reaktion mit überschüssig eingesetztem Säurechlorid einer Acrylsäure verestert, wodurch das erfindungsgemäße Polymer (1) erhalten wird.

Durch Hinzumischung gebräuchlicher Zusätze zum Polymeren (1), wie 2 bis 20 Gewichtsprozent Vernetzungsverstärker oder reaktiver Verdünner, Photoinitiatoren und Radikalfänger als Stabilisatoren wird bereits gebrauchsfertiges aber auch lagerfähiges Harz erhalten, das als Negativphotoresist eingesetzt werden kann. Gegebenenfalls kann für verschiedene Anwendungszwecke die Viskosität durch Verdünnung mit Lösungsmitteln herabgesetzt werden.

Vernetzungsverstärker oder auch Modifier genannt sind zumeist polyfunktionelle niedermolekulare Verbindungen mit mehreren vernetzungsfähigen bzw. lichtempfindlichen Gruppen, durch die bei Bestrahlung eine stärkere Vernetzung der überwiegend linearen Hauptketten der Poly- bzw. Oligomeren ermöglicht wird. Sind funktionelle lichtempfindliche Gruppen der Vernetzungsverstärker mit denen des Poly- bzw. Oligomeren identisch, spricht man auch von reaktivem Verdünner.

Geeignete Vernetzungsverstärker für die erfindungsgemäßen Polymere (1) bilden daher die Acrylate von Mehrfachalkoholen, wie zum Beispiel Pentaerythritoltri- bzw. Tetraacrylat, Dipentaerythritolpentaacrylat oder Trimethylolpropantriacrylat. Auch die entsprechenden Methacrylate sind geeignet, wohingegen die entsprechenden Zimtsäureester für diese Verwendung untauglich sind. Weiterhin liegt es im Rahmen der Erfindung, fluorierte Vernetzungsverstärker zu verwenden und durch die Einführung weiterer aliphatischer C-F-Bindungen die dielektrischen Eigenschaften des vernetzten Harzes noch zu verbessern.

Eine weitere Ausführungsform der Erfindung betrifft Polymere der Strukturformel 1, bei denen der Index k gleich 0 ist und somit das fluorierte aliphatische Zwischenglied X entfällt. Bei Veresterung mit entsprechend hoch fluorierten Acrylsäuren und unter Einbeziehung fluorierter Bisphenolreste werden mit diesen Polymeren ebenfalls gute thermische und elektrische Werte erreicht.

Anwendung finden die erfindungsgemäßen Harze vor allem als Photoresist zur Definition von Mikroverdrahtungsstrukturen bei elektronischen Bauelementen. Wegen seiner guten elektrischen Eigenschaften im vernetzten Zustand, die sich auch bei Behandlung mit Lösungsmitteln nicht verschlechtern, ist der Photoresist auch bestens zum Verbleib auf dem entsprechenden Bauelement geeignet. Doch auch als Isolations-, Passivierungs-, Planarisierungs- oder anderweitige Abdeckschicht von elektronischen Bauelementen ist das durch UV-Licht härtbare Harz zu verwenden. Weitere mögliche Anwendungen sind als Beschichtungsmaterial von Lichtwellenleiterfasern, oder wegen der chemischen Stabilität als korrosionshemmender Überzug von Metallteilen, die korrodierenden Bedingungen in Atmosphäre, Wasser oder anderen Chemikalien ausgesetzt sind, gegeben.

Im folgenden wird das Verfahren zum Herstellen des erfindungsgemäßen Harzes anhand eines Ausführungsbeispiels noch näher erläutert.

Der bekannte Diglycidylether des Hexafluorpropyl-analogen von Bisphenol A wird nach der Methode von Kelly et al in Journal of Applied Polymer Science VI, 22, Seite 425 (1962) aus dem fluorierten Bisphenol $HO-C_6H_4-C_3F_6-C_6H_2-OH$ und einem Überschuß Epichlorhydrin mit Natronlauge erhalten. Nach Abziehen des Lösungsmittels und nicht umgesetzten Epichlorhydrins im Vakuum wird das Monomer des Diglycidylethers aus reichlich Methanol umkristallisiert. Dieses Monomer wird mit einem leichten Überschuß 2,2,3,3, 4,4-Hexafluorpentan-1,5-diol bei 100 °C in tertiären Amylalkohol mit Dimethylbenzylamin als Katalysator umgesetzt. Der erhaltene Polyfluoralkyldiglycidylether reagiert schließlich mit einem 2,5-fachen Überschuß (bezogen auf die freien OH-Gruppen des Ethers) an Zimtsäurechlorid unter Zugabe von ca. 0,5 % 4-N,N Dimethylaminopyridin in Toluol zum Polymeren 1, welches sich aus Alkohol kristallin isolieren läßt.

Zur Verarbeitung läßt sich das weiße glänzende Produkt (1) in gängigen Lösungsmitteln, wie zum Beispiel Toluol, gut lösen und bedarf trotz des Fluorgehalts keiner fluorierten Lösungsmittel. Dazu werden ca. 5 Gewichtsprozent, bezogen auf (1) an Pentaerythritoltetraacrylat als Vernetzungsverstärker und wenig Michler's Keton als Photoinitiator gegeben.

Die Harzmischung wird in einer dünnen Schicht auf einem Substrat aufgetragen und mit UV-Licht vernetzt. Das Polymer weist eine Glasübergangstemperatur von 110 °C auf, während die elektrischen Werte

zu $\epsilon_r$ gleich 3,4 und Tangens $\delta$ gleich $1,4 \times 10^{-2}$ bestimmt werden.

Da auch die Dauertemperaturbeständigkeit bei über 100 °C liegt, ist der gehärtete Lack bestens als Dielektrikum für elektro nische Bauelemente geeignet.

## Ansprüche

1. Durch Strahlung zu einem thermisch und chemisch stabilen Polymersystem vernetzbares Harz mit substituierten Acrylestergruppierungen als strahlungsempfindliche Struktureinheiten, **dadurch gekennzeichnet,** daß das Harz überwiegend Polymere der allgemeinen Strukturformel (1) enthält

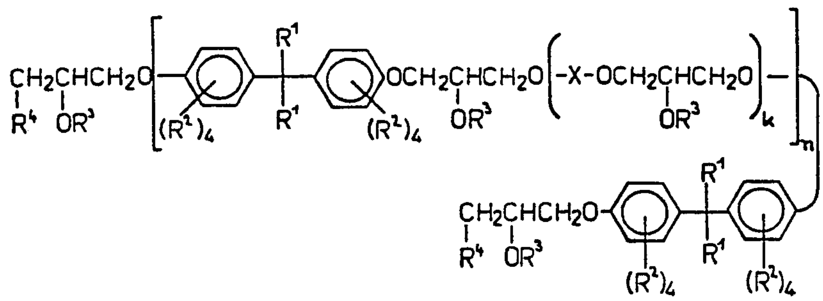

(1)

worin

X einen zweiwertigen, mindestens zum Teil fluorierten und im wesentlichen linearen aliphatischen Rest mit 2 bis 10 C-Atomen darstellt,

$R^3$ den Acylrest einer substituierten Acrylsüre bedeutet,

die Reste $R^1$ unabhängig voneinander Methyl oder Trifluormethylreste sind,

die Reste $R^2$ unabhängig voneinander H, F, Br, $OR^3$, $CH_2OR^3$, $CH_3$ oder $CF_3$ sind,

die Endgruppen $R^4$ einen Chlorrest oder $OXOR^3$ darstellen,

k die Zahl 1 bedeutet, sowie

n eine ganze Zahl zwischen 1 und 20 ist,

und daß die übrigen Bestandteile des Harzes wahlweise für lichtempfindliche Mischungen übliche Zusätze sind, wie Vernetzungsverstärker, Photoinitiatoren und Stabilisatoren.

2. Harz nach Anspruch 1, **dadurch gekennzeichnet,** daß die substituierte Acrylsäure Zimtsäure, Furanacryl säure, para-Trifluormethylzimtsäure oder 2-(Pentafluorphenyl)-acrylsäure ist.

3. Harz nach Anspruch 1 oder 2, **dadurch gekennzeichnet,** daß der aliphatische Rest X die allgemeine Strukturformel (2)

$HO-CH_2(CF_2)_\ell CH_2-OH$ (2)

mit $3 \leq 1 \leq 5$ besitzt.

4. Harz nach mindestens einem der Ansprüche 1 bis 3, **dadurch gekennzeichnet,** daß der Vernetzungsverstärker ausgewählt ist aus der Gruppe Pentaerythritoltriacrylat, Pentaerythritoltetraacrylat, Dipentaerythritolpentaacrylat, Trimethylolpropantriacrylat oder einem der entsprechenden Methacrylate.

5. Harz nach mindestens einem der Ansprüche 1 bis 3, **dadurch gekennzeichnet,** daß der Vernetzungsverstärker aliphatische C-F-Bindungen enthält und ein mit Acrylsäure veresterter niedermolekularer Mehrfachalkohol ist.

6. Harz nach mindestens einem der Ansprüche 1 bis 5, **dadurch gekennzeichnet,** daß der Index k der Summenformel (1) gleich 0 ist.

7. Verfahren zum Herstellen eines strahlungsvernetzbaren Harzes, **gekennzeichnet durch** folgende Schritte:

a) Umsetzen eines fluorierten Diglycidylethers auf Bisphenol A ähnlicher Basis mit einem im wesentlichen linearen, zumindest zum Teil fluorierten aliphatischen Diol mit 2 bis 10 C-Atomen,

b) vollständige Veresterung der freien OH Gruppen und der Epoxidgruppen mit dem Säurechlorid einer substituierten Acrylsäure und

c) Zumischen von für strahlungsvernetzbare Harze üblichen Zu sätzen.

8. Verfahren nach Anspruch 7, **dadurch gekennzeichnet,** daß das aliphatische Diol der allgemeinen Summenformel 2 entspricht, wobei l eine ganze Zahl mit $3 \leq 1 \leq 5$ darstellt.

9. Verfahren nach Anspruch 7 und oder 8, **dadurch gekennzeichnet,** daß die substituierte Acrylsäure Furanacrylsäure, Zimtsäure, para-Trifluormethylzimtsäure oder 2 (Pentafluorphenyl) acrylsäure ist.

10. Verwendung des erfindungsgemäßen Harzes als Negativphotoresist und Dielektrikum, insbesondere für Mikroverdrahtungen.

11. Verwendung des erfindungsgemäßen Harzes als korrosionsbeständiges lichthärtendes Überzugsmaterial, insbesondere für Lichtwellenleiterfasern.